# FASCICULE DE BREVET EUROPEEN

(11) **EP 0 550 345 B1**
(45) Date de publication et mention de la délivrance du brevet: **03.07.1996**
(21) Numéro de dépôt: 92403585.0
(22) Date de dépôt: 30.12.1992
(51) Int. Cl.: A62C 3/00, F16L 59/02, B64G 1/58

(54) **Boîte noire pour aéronefs**
Registriergerätgehäuse für Flugdaten von Flugzeugen
Aircraft data recorder box

(30) Priorité: 31.12.1991 FR 9116399
(43) Date de publication de la demande: 07.07.1993
(73) Titulaire: SFIM INDUSTRIES, F-91300 Massy (FR)
(72) Inventeur: Christien, Gilbert, F-91120 Palaiseau (FR); Daoulas, Yvon, F-75017 Paris (FR)
(74) Mandataire: Schrimpf, Robert

(56) Documents cités:
- DE-A- 2 009 398
- GB-A- 1 498 177
- US-A- 4 944 401

## Description

L'invention concerne un dispositif de protection mécanique et thermique et elle s'applique tout particulièrement à la protection des enregistreurs de données installés à bord des aéronefs ou similaires pour conserver en mémoire les circonstances du vol et qui doivent pouvoir résister aux chocs mécaniques et aux chocs thermiques intervenus en vol ou à la suite de la chute de l'aéronef ("boîte noire").

Il est connu d'obtenir cette protection en disposant les éléments enregistreurs dans une boîte interne placée à l'intérieur d'une boîte externe, métallique et à parois épaisses, qui assure la protection mécanique, l'espace entre les deux boîtes étant remplis par un ou plusieurs matériaux de protection thermique.

Le brevet GB-A-1 498 677 décrit ainsi un dispositif de ce type dans lequel les matériaux de protection thermique comprennent un sel contenant de l'eau de cristallisation et susceptible de libérer cette eau sous l'action de la chaleur, ce sel étant placé à l'intérieur de la boîte interne (ou autour de cette boîte) et étant entouré par une matière d'isolation thermique stable vendue dans le commerce sous la marque MICROTHERM.

L'utilisation d'un tel sel présente l'inconvénient que, sous l'action du froid, par exemple en cas de stockage ou d'exposition accidentelle à basse température (de 0°C à -65°C), le sel se dilate et exerce des contraintes mécaniques qui tendent à faire éclater les boîtes interne et externe, à moins que l'on ne prévoit des vides tampons, lesquels réduisent le volume utile, la résistance mécanique et l'isolement thermique.

La présente invention vise à éviter ces inconvénients. On y parvient, selon l'invention, au moyen d'un dispositif qui comprend une boîte interne qui contient les éléments à protéger, par exemple un enregistreur à mémoires statiques, une boîte externe placée autour de la boîte interne et qui est résistante aux chocs mécaniques et, dans l'espace entre ces deux boîtes, un remplissage d'un matériau réservoir constituant un solide doué de résistance mécanique, contenant de l'eau susceptible d'être libérée sous l'action de la chaleur et comportant de multiples cavités suffisantes pour éviter la dilation du matériau sous l'effet du froid, entouré par un remplissage d'un isolant thermique stable, ces deux remplissages étant séparés par une couche apte à réfléchir une partie du flux calorifique qui traverserait l'isolant thermique stable en cas d'incendie.

Le mot isolant thermique stable signifie que cet isolant ne change pas d'état lors d'une variation de température.

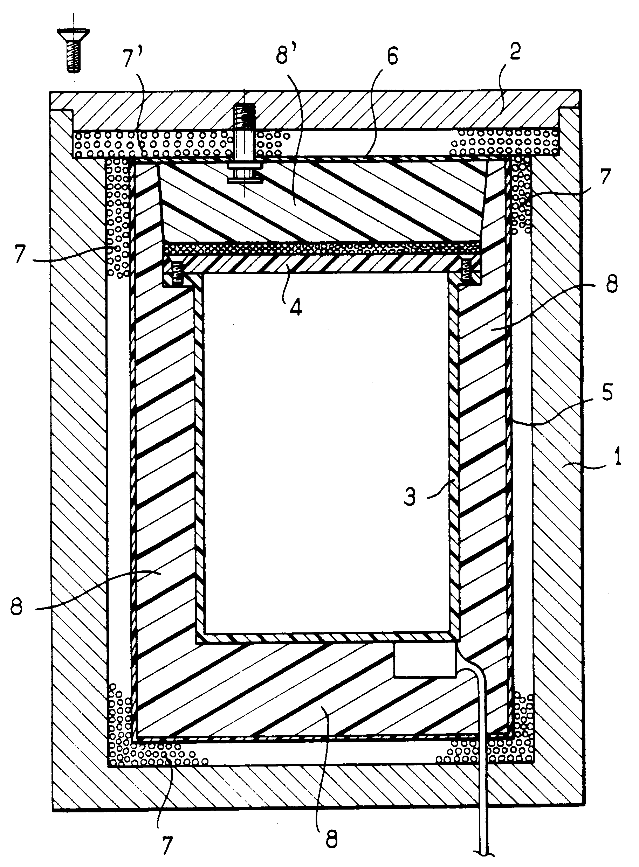

On décrira ci-après un exemple de réalisation d'un dispositif de protection conforme à l'invention, en référence à la figure unique du dessin joint qui est une coupe verticale du dispositif.

Le dispositif est constitué d'une boîte extérieure, une boîte intérieure et de remplissages entre ces deux boîtes.

La boîte externe est constituée d'un corps de boîte 1 ouvert sur une face, en l'espèce la face supérieure, et d'un couvercle 2 qui ferme la face ouverte. Le couvercle est démontable pour pouvoir accéder à l'intérieur de la boîte. Le matériau et l'épaisseur des parois de cette boîte sont choisis, de façon connue en soi, pour éviter une déformation des parois en cas de chute de l'avion. On utilise par exemple des parois en acier à très haute résistance d'une épaisseur de 3 à 6 mm, de préférence 4 à 5 mm, encore mieux voisine de 4,5 mm.

La boîte interne est, dans cet exemple, une boîte étanche constituée d'un corps de boîte 3 ouvert à sa face supérieure et d'un couvercle amovible 4 qui ferme cette ouverture. Cette boîte interne peut également être métallique mais, de préférence, elle est en matière plastique composite choisie pour avoir une meilleure conductivité thermique dans le plan de la paroi que transversalement à la paroi, par exemple les parois de la boîte interne sont constituées par un empilement de renforts à fibres longues de carbone liées par une matrice. On obtient ainsi que le flux thermique qui atteint la boîte interne a plus tendance à se répartir sur le pourtour de la boîte que de traverser la paroi de la boîte.

Ces deux boîtes déterminent entre elles un intervalle qui entoure complètement la boîte interne et qui contient une boîte intermédiaire dont la paroi constitue un réflecteur thermique apte à réfléchir vers la boîte externe une partie du flux de chaleur qui atteindrait la boîte intermédiaire en cas d'incendie.

Cette boîte intermédiaire est par exemple constituée par un corps de boîte 5 en acier inoxydable d'une épaisseur comprise entre 0,1 et 0,20 mm, par exemple voisine de 0,15 mm, ce corps de boîte étant ouvert sur un côté et ce côté étant fermé par un couvercle 6 constitué du même matériau que le corps de boîte 5.

L'intervalle entre la boîte intermédiaire et la boîte externe dont l'épaisseur est de préférence de l'ordre de 2 à 3 mm, est rempli par un matériau d'isolation (7,7') ayant de bonnes propriétés d'isolation thermique et, par exemple, par une masse alvéolaire à alvéoles fermés, notamment une structure cellulaire en silice ayant des cavités extrêmement petites et comprenant des oxydes métalliques comme réflecteur (par exemple TiO₂ ou Fe₂O₃). Pour la clarté de la figure, cette masse n'a été représentée que partiellement par des petits cercles 7.

Si on le désire, on peut remplacer la boîte intermédiaire par une couche réfléchissante appliquée sur la face de la masse 7,7' qui est tournée vers la boîte interne.

Il est notamment préconisé d'utiliser comme masse 7,7' le matériau "MICROTHERM" de MICROPORE INTERNATIONAL LIMITED, constitué approximativement de 65% de silice et de 30% d'oxyde de titane en poudre, compacté en cellules de diamètre avoisinant 0,1 micromètre, créant ainsi environ 90% de vide sans mouvement de convection possible.

Le MICROTHERM est disponible habituellement à l'état de feuille et est appliqué contre la face interne de la boîte extérieure avant la mise en place de la boîte intermédiaire et en tant que couvercle.

Entre la boîte intermédiaire et la boîte interne, il existe un intervalle ayant, de préférence, une épaisseur de 8 à 15 mm et encore mieux de 10 à 13,5 mm, intimement rempli d'un matériau réservoir 8,8' constituant un solide doué de résistance mécanique, contenant de l'eau susceptible d'être libérée sous l'action de la chaleur et comportant de multiples cavités suffisantes pour éviter la dilatation du matériau sous l'effet du froid. Un matériau particulièrement approprié est une masse zéolithique, notamment une masse obtenue par polycondensation in situ d'aluminosilicates de sodium ou de potassium. La polycondensation d'aluminosilicates de sodium ou de potassium, en milieu alcalin, est décrite dans diverses publications, par exemple dans les publications de brevets telles que le brevet français FR-A-2 464 227 et différents articles de Mr. J. DAVIDOVITS, notamment "Synthesis of new high-temperature geopolymers for reinforced plastics/composites" (Society of Plastics Engineers, Inc, PACTEC'79), "Processing and applications of ultra-high temperature, inorganic matrix resin for cast composite structure..." (PACTEC'83).

Selon l'invention, on supprime l'étape de séchage habituellement préconisée pour stabiliser le matériau après polycondensation, afin de conserver dans le matériau suffisamment d'eau de polycondensation, en sorte qu'en cas d'incendie on dispose d'une protection thermique suffisante. Cette eau libre se trouve à l'état suffisamment fractionnée pour ne pas engendrer de dilatation du matériau exposé au froid.

De tels produits sont vendus sous la marque GEOPOLYMITE par la société GEOPOLYMERE-France et permettent d'obtenir des solides moulés ayant une résistance mécanique suffisante.

On a constaté qu'avec une telle matière la présence du réflecteur (5,6) et de l'isolant thermique stable sont particulièrement utile car, en limitant la température à laquelle est soumise la matière 8,8' en cas d'incendie, elle permet d'éviter que cette matière présente des phénomènes de réaction exothermique. D'autre part, la boîte intermédiaire présente également l'avantage d'empêcher un contact direct entre l'isolant MICROTHERM et la matière 8,8', ce qui permet de réaliser in situ la polycondensation en milieu alcalin donnant naissance à la matière 8,8'. L'isolant thermique stable en effet serait attaqué par ce milieu alcalin en cas d'un contact direct avec la matière 8,8' pendant la polycondensation.

L'invention permet donc de remplir l'espace entre la boîte interne et la boîte intermédiaire avec la mélange qui donnera naissance au matériau 8,8', ce qui assurera un contact intime entre le matériau 8,8' et la boîte intermédiaire. Il est en effet important d'éviter la création de vide entre ce matériau et la boîte intermédiaire.

On notera que les masses solides 7 et 8 amovibles peuvent être considérées comme constituant elles-mêmes des boîtes ayant des couvercles 7',8', en sorte que dans cette conception le dispositif est en fait constitué d'un ensemble de boîtes gigognes.

Les boîtes peuvent avoir toute forme de section droite horizontale désirée et, par exemple, une section droite horizontale carrée, rectangulaire ou circulaire.

L'invention s'applique à la protection de tout objet pour lequel on recherche à la fois une protection thermique et une protection mécanique aux chocs.

## Revendications

1. Dispositif de protection mécanique et thermique, notamment pour la protection des enregistreurs de données des circonstances de vol d'un aéronef, qui comprend une boîte interne (3,4) qui contient les éléments à protéger, une boîte externe (1,2) placée autour de la boîte interne et qui est résistante aux chocs mécaniques et, dans l'espace entre ces deux boîtes, un remplissage (8,8') d'un matériau réservoir constituant un solide doué de résistance mécanique, contenant de l'eau susceptible d'être libérée sous l'action de la chaleur et comportant de multiples cavités suffisantes pour éviter la dilation du matériau sous l'effet du froid, ce remplissage étant entouré par un remplissage (7,7') d'un isolant thermique stable, ces deux remplissages étant séparés par une couche (5,6) apte à réfléchir une partie du flux calorifique qui traverserait l'isolant thermique stable.

2. Dispositif de protection selon la revendication 1, caractérisé en ce que ladite couche (5,6) interposée entre les deux remplissages est constituée par une paroi dont une face au moins est réfléchissante et tournée du côté du remplissage en isolant thermique stable.

3. Dispositif selon la revendication 2, caractérisé en ce que ladite couche (5,6) est la paroi d'une boîte intermédiaire entre les boîtes interne et externe.

4. Dispositif selon la revendication 1, 2 ou 3, caractérisé en ce que le matériau réservoir (8,8') est un matériau de structure zéolithique.

5. Dispositif selon la revendication 4, caractérisé en ce que le matériau réservoir est obtenu par polycondensation, en milieu alcalin, d'aluminosilicates de sodium ou de potassium, réalisée in situ.

6. Dispositif selon l'une des revendications précédentes, caractérisé en ce que ledit matériau réservoir (8,8') occupe un espace dont l'épaisseur est de 8 à 15 mm, de préférence 10 à 13,5 mm.

7. Dispositif de protection selon l'une des revendications précédentes, caractérisé en ce que ledit isolant thermique stable (7,7') remplit un espace dont l'épaisseur est de 2 à 3 mm.

8. Dispositif selon l'une des revendications précédentes, caractérisé en ce que ladite couche (5,6) interposée entre les deux remplissages a une épaisseur comprise entre 0,1 et 0,20 mm.

9. Dispositif selon l'une des revendications précédentes, caractérisé en ce que ladite boîte interne est en matière plastique composite choisie pour avoir une meilleure conductivité thermique dans le plan de la paroi de la boîte que transversalement à cette paroi.

10. Dispositif selon la revendication 9, caractérisé en ce que ladite boîte interne a sa paroi constituée par un empilement de renfort à fibres de carbone longues liées par une matrice.

11. Dispositif selon l'une des revendications précédentes, caractérisé en ce que la boîte externe a des parois en acier d'une épaisseur de 3 à 6 mm, de préférence 4 à 5 mm.

12. Dispositif selon l'une des revendications précédentes, caractérisé en ce que l'isolant thermique stable (7,7') est une masse alvéolaire à alvéoles fermés.

13. Dispositif selon l'une des revendications précédentes, caractérisé en ce que l'isolant termique stable (7,7') et le matériau réservoir (8,8') constituent des boîtes interposées entre la boîte interne (3,4) et la boîte externe (1,2).

## Claims

1. A device for providing mechanical and thermal protection, in particular for protecting recorders for recording data concerning flight circumstances of an aircraft, which device comprises an inner box (3, 4) that contains the elements to be protected, an outer box (1, 2) placed around the inner box and which withstands mechanical shocks, and in the space between the two boxes, a filling (8, 8') of a reservoir material constituting a solid that has mechanical strength, that contains water suitable for being released under the action of heat, and that includes sufficient multiple cavities to avoid the material expanding under the effect of cold, said filling being surrounded by a filling (7, 7') of a stable thermal insulator, said two fillings being separated by a layer (5, 6) suitable for reflecting a portion of any heat flux passing through the stable thermal insulator.

2. A device according to claim 1, characterized in that said layer (5, 6) interposed between the two fillings is constituted by a wall having at least one face that is reflective and faces the filling of stable thermal insulation.

3. A device according to claim 2, characterized in that said layer (5, 6) is the wall of an intermediate box between the inner box and the outer box.

4. A device according to claim 1, 2, or 3, characterized in that the reservoir material (8, 8') is a material of zeolitic structure.

5. A device according to claim 4, characterized in that the reservoir material is obtained by polycondensation in alkaline medium of sodium or potassium alumino-silicates, performed in situ.

6. A device according to any preceding claim, characterized in that said reservoir material (8, 8') occupies a space that is 8 mm to 15 mm across, and that is preferably 10 mm to 13·5 mm across.

7. A device according to any preceding claim, characterized in that said stable thermal insulation (7, 7') fills a space having a thickness lying in the range 2 mm to 3 mm.

8. A device according to any preceding claim, characterized in that said layer (5, 6) interposed between the two fillings has a thickness lying in the range 0·1 mm to 0·20 mm.

9. A device according to any preceding claim, characterized in that said inner box is made of a composite plastic selected for having thermal conductivity in the plane of the wall of the box that is better than its thermal conductivity through said wall.

10. A device according to claim 9, characterized in that the inner box has its wall constituted by a stack of long carbon reinforcing fibers that are bonded together by a matrix.

11. A device according to any preceding claim, characterized in that the outer box has steel walls that are 3 mm to 6 mm thick, and that are preferably 4 mm to 5 mm thick.

12. A device according to any preceding claim, characterized in that the stable thermal insulation (7, 7') is a cellular mass having closed cells.

13. A device according to any preceding claim, characterized in that the stable thermal insulation (7, 7') and the reservoir material (8, 8') constitute boxes interposed between the inner box (3, 4) and the outer box (1, 2).

## Patentansprüche

1. Mechanische und thermische Schutzvorrichtung, insbesondere zum Schutz der Registriergeräte für die Flugdaten eines Flugzeugs, die ein inneres, die zu schützenden Elemente enthaltendes Gehäuse (3, 4), ein äußeres, um das innere Gehäuse herum angeordnetes und mechanischen Stößen widerstehendes Gehäuse (1, 2) sowie im Raum zwischen den beiden Gehäusen eine Füllung (8, 8') aus einem Behälterstoff umfaßt, der einen mechanische Festigkeit besitzenden Feststoff darstellt und Wasser, das unter der Einwirkung von Wärme freigesetzt werden kann, sowie zahlreiche Hohlräume enthält, die dazu ausreichen, eine Ausdehnung des Stoffes unter Kälteeinwirkung zu verhindern, wobei diese Füllung von einer Füllung (7, 7') aus einem stabilen thermischen Isoliermaterial umgeben ist, wobei diese beiden Füllungen durch eine Schicht (5, 6) getrennt sind, die einen Teil des gegebenenfalls das stabile thermische Isoliermaterial durchdringenden Wärmeflusses reflektieren kann.

2. Schutzvorrichtung nach Anspruch 1, dadurch gekennzeichnet, daß besagte, zwischen den beiden Füllungen eingesetzte Schicht (5, 6) aus einer Wand besteht, von der mindestens eine Seite reflektierend und der Seite der Füllung aus thermischem stabilem Isoliermaterial zugekehrt ist.

3. Vorrichtung nach Anspruch 2, dadurch gekennzeichnet, daß besagte Schicht (5, 6) die Wand eines Zwischengehäuses zwischen dem inneren und äußeren Gehäuse ist.

4. Vorrichtung nach Anspruch 1, 2 oder 3, dadurch gekennzeichnet, daß der Behälterstoff (8, 8') ein Stoff mit Zeolithstruktur ist.

5. Vorrichtung nach Anspruch 4, dadurch gekennzeichnet, daß der Behälterstoff durch an Ort und Stelle in alkalischem Milieu durchgeführte Polykondensation von Natrium- oder Kaliumaluminosilikaten erhalten wird.

6. Vorrichtung nach einem der vorhergehenden Ansprüche, dadurch gekennzeichnet, daß besagter Behälterstoff (8, 8') einen Raum einnimmt, dessen Dicke 8 bis 15 mm, vorzugsweise 10 bis 13,5 mm, einnimmt.

7. Schutzvorrichtung nach einem der vorhergehenden Ansprüche, dadurch gekennzeichnet, daß besagter stabiler thermischer Isolierstoff (7, 7') einen Raum ausfüllt, dessen Dicke 2 bis 3 mm beträgt.

8. Vorrichtung nach einem der vorhergehenden Ansprüche, dadurch gekennzeichnet, daß besagte zwischen den beiden Füllungen eingesetzte Schicht (5, 6) eine Dicke zwischen 0,1 und 0,20 mm aufweist.

9. Vorrichtung nach einem der vorhergehenden Ansprüche, dadurch gekennzeichnet, daß besagtes innere Gehäuse aus einem so ausgewählten Verbundkunststoff besteht, daß dessen Wärmeleitfähigkeit in der Ebene der Gehäusewand größer als quer zu dieser Wand ist.

10. Vorrichtung nach Anspruch 9, dadurch gekennzeichnet, daß die Wand besagten inneren Gehäuses aus einer Verstärkungsschicht aus langen, durch eine Grundmasse verbundenen Kohlenstoffasern besteht.

11. Vorrichtung nach einem der vorhergehenden Ansprüche, dadurch gekennzeichnet, daß das äußere Gehäuse Stahlwände einer Dicke von 3 bis 6 mm, vorzugsweise 4 bis 5 mm, aufweist.

12. Vorrichtung nach einem der vorhergehenden Ansprüche, dadurch gekennzeichnet, daß das stabile thermische Isoliermaterial (7, 7') ein Schaumstoff mit geschlossenen Zellen ist.

13. Vorrichtung nach einem der vorhergehenden Ansprüche, dadurch gekennzeichnet, daß das stabile thermische Isoliermaterial (7, 7') und der Behälterstoff (8, 8') Gehäuse darstellen, die zwischen dem inneren Gehäuse (3, 4) und dem äußeren Gehäuse (1, 2) eingesetzt sind.
